(19) Europäisches Patentamt
European Patent Office
Office européen des brevets

(11) Veröffentlichungsnummer: **0 284 938 B1**

(12) # EUROPÄISCHE PATENTSCHRIFT

(45) Veröffentlichungstag der Patentschrift: **10.11.93**

(51) Int. Cl.$^5$: **G03F 7/027**, G03F 7/031

(21) Anmeldenummer: **88104464.8**

(22) Anmeldetag: **21.03.88**

Die Akte enthält technische Angaben, die nach dem Eingang der Anmeldung eingereicht wurden und die nicht in dieser Patentschrift enthalten sind.

(54) **Photopolymerisierbares Gemisch und daraus hergestelltes Aufzeichnungsmaterial.**

(30) Priorität: **28.03.87 DE 3710282**

(43) Veröffentlichungstag der Anmeldung:
**05.10.88 Patentblatt 88/40**

(45) Bekanntmachung des Hinweises auf die Patenterteilung:
**10.11.93 Patentblatt 93/45**

(84) Benannte Vertragsstaaten:
**DE FR GB NL**

(56) Entgegenhaltungen:
**EP-A- 0 014 293**
**DE-A- 2 125 457**
**DE-A- 2 822 190**
**FR-A- 2 375 256**
**GB-A- 1 193 923**
**US-A- 3 479 185**
**EP-A- 0 097 012**
**DE-A- 2 361 041**
**DE-A- 3 602 093**
**GB-A- 1 165 570**
**JP-A-61 228 002**
**US-A- 4 399 211**

(73) Patentinhaber: **HOECHST AKTIENGESELL-SCHAFT**

**D-65926 Frankfurt(DE)**

(72) Erfinder: **Frass, Werner, Dr.**
**Erbsenacker 37**
**D-6200 Wiesbaden(DE)**
Erfinder: **Mohr, Dieter, Dr,**
**Eaubonner Strasse 8**
**D-6501 Budenheim(DE)**
Erfinder: **Rode, Klaus, Dr.**
**Habelstrasse 5**
**D-6200 Wiesbaden(DE)**

**EP 0 284 938 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein photopolymerisierbares Gemisch, das ein polymeres Bindemittel, eine polymerisierbare Verbindung mit mindestens zwei Acryl- oder Alkacrylsäureestergruppen im Molekül sowie einen Photoinitiator enthält.

Photopolymerisierbare Gemische, die als polymerisierbare Verbindungen Acryl- und/oder Methacrylsäureester enthalten, sind bekannt. Für die Herstellung von Photoresistmaterialien, insbesondere von Trockenphotoresistschichten, werden dabei Gemische bevorzugt, die Acryl- oder Methacrylsäureester mit Urethangruppen im Molekül enthalten und die sich mit wäßrig-alkalischen Lösungen entwickeln lassen. Derartige Gemische sind z. B. in der DE-A 28 22 190, der DE-B 21 15 373, der DE-C 23 61 041 und den US-A 3 850 770 und 3 960 572 beschrieben.

Andererseits sind auch photopolymerisierbare Gemische bekannt, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten. Derartige synergistisch wirkende Gemische sind z. B. in den DE-A 26 02 419 und 22 51 048 und der US-A 3 759 807 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen können.

In der JP-A 50/129 214, angemeldet am 2.4.1974 unter der Nummer 49/36614, wird ein photopolymerisierbares Gemisch beschrieben, das als polymerisierbare Verbindung einen Tetra(meth)acrylsäureester eines N,N,N′,N′-Tetrahydroxyalkyl-alkylendiamins enthält. Die tetrafunktionelle Verbindung dient als Vernetzungsmittel.

Es ist weiterhin bekannt, daß man die radikalische Polymerisation von ethylenisch ungesättigten Verbindungen durch Bestrahlung mit sichtbarem Licht in Gegenwart von photoreduzierbaren Farbstoffen und Reduktionsmitteln, z. B. Aminen, anstoßen kann (US-A 3 097 096). Diese Initiatorkombinationen werden jedoch im wesentlichen nur in wäßriger Lösung oder in Kombination mit wasserlöslichen Bindemitteln eingesetzt.

Initiatorkombinationen aus photoreduzierbaren Farbstoffen und anderen Reduktionsmitteln sind in den US-A 3 597 343 und 3 488 269 beschrieben. Photopolymerisierbare Gemische, die als Initiatoren ausschließlich photoreduzierbare Farbstoffe enthalten, sind wegen ihrer zu geringen Lichtempfindlichkeit bisher praktisch nicht eingesetzt worden.

Aufgabe der Erfindung war es, photopolymerisierbare Gemische vorzuschlagen, die sich zur Herstellung von Druckplatten hoher Auflagenleistung und Photoresists mit hoher Resistenz gegen Verarbeitungslösungen im gehärteten Zustand eignen und die sich ferner durch eine hohe Lichtempfindlichkeit im nahen Ultraviolett- und im sichtbaren Spektralbereich auszeichnen.

Erfindungsgemäß wird ein photopolymerisierbares Gemisch vorgeschlagen, das als wesentliche Bestandteile

a) ein polymeres Bindemittel,

b) einen Acryl- oder Alkacrylsäureester eines mehrwertigen Alkohols und

c) einen photoreduzierbaren Farbstoff als Photoinitiator enthält.

Das erfindungsgemäße Gemisch ist dadurch gekennzeichnet, daß der Acryl- oder Alkacrylsäureester eine oder mehrere bei Belichtung in Gegenwart des photoreduzierbaren Farbstoffs photooxydierbare Gruppen und eine oder mehrere Urethangruppen aufweist.

Als photooxydierbare Gruppen kommen insbesondere Aminogruppen, Thiogruppen, die auch Bestandteile heterocyclischer Ringe sein können, Enolgruppen und Carboxylgruppen in Kombination mit olefinischen Doppelbindungen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Mit besonderem Vorteil werden Acryl- und Alkacrylsäureester der Formel I

$$R_{(m-n)}Q[(-CH_2-\underset{R^2}{\overset{R^1}{C}}O)_a-CONH(X^1-NHCOO)_b-X^2(-OOC-\overset{R^3}{C}=CH_2)_c]_n \quad (I)$$

eingesetzt, worin

Q -Ń-, -Ń-E-Ń-,

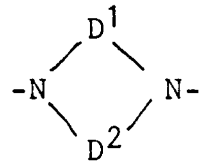

oder -S

R eine Alkyl-, Hydroxyalkyl- oder Arylgruppe,

$R^1$ und $R^2$ jeweils ein Wasserstoffatom, eine Alkylgruppe oder Alkoxyalkylgruppe,

$R^3$ ein Wasserstoffatom, eine Methyl- oder Ethylgruppe`

$X^1$ eine gesättigte Kohlenwasserstoffgruppe mit 2 bis 12 Kohlenstoffatomen,

$X^2$ eine (c+1)-wertige gesättigte Kohlenwasserstoffgruppe, in der bis zu 5 Methylengruppen durch Sauerstoffatome ersetzt sein können,

D1 und $D^2$ jeweils eine gesättigte Kohlenwasserstoffgruppe mit 1 bis 5 Kohlenstoffatomen,

E eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,

a 0 oder eine ganze Zahl von 1 bis 4,

b 0 oder 1,

c eine ganze Zahl von 1 bis 3,

m je nach Wertigkeit von Q 2, 3 oder 4 und

n eine ganze Zahl von 1 bis m

bedeutet, wobei alle Reste gleicher Definition untereinander gleich oder verschieden sein können.

Die Verbindungen dieser Formel, ihre Herstellung und Verwendung sind ausführlich in der gleichzeitig eingereichten Patentanmeldung ......... (Hoe 87/K012) beschrieben.

Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatome substituiert sein.

Wenn $R^1$ und $R^2$ Alkyl- oder Alkoxyalkylgruppen sind, können diese 1 bis 5 Kohlenstoffatome enthalten.

$R^3$ ist bevorzugt ein Wasserstoffatom oder eine Methylgruppe, insbesondere eine Methylgruppe.

$X^1$ ist bevorzugt ein geradkettiger oder verzweigter aliphatischer oder cycloaliphatischer Rest mit vorzugsweise 4 bis 10 Kohlenstoffatomen.

$X^2$ hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. $X^2$ kann auch eine cycloaliphatische Gruppe mit 5 bis 10 Kohlenstoffatomen, insbesondere eine Cyclohexylgruppe sein.

$D^1$ und $D^2$ können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Der Wert von c ist vorzugsweise 1.

Die polymerisierbaren Verbindungen der Formel I mit Q = N und n = m, die zwei Urethangruppen in jedem Rest (b = 1) enthalten, werden dargestellt, indem Acryl- oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen umgesetzt wird. Wenn a = 0 ist,

entsteht eine Harnstoffgruppierung.

Beispiele für die als Ausgangsstoffe verwendeten Hydroxyalkylamine sind Triethanolamin, N-Alkyl-N,N-di(hydroxyalkyl)amine, Diethanolamin, Tris-(2-hydroxypropyl)amin oder Tris-(2-hydroxybutyl)amin.

Beispiele für die als Ausgangsstoffe verwendeten Diisocyanate sind Ethylendiisocyanat, Propylendiisocyanat, Butylen-1,3-diisocyanat, Hexamethylendiisocyanat, 2,2,4-Trimethyl-hexamethylendiisocyanat, 2,4-Dimethyl-6-ethyl-octamethylendiisocyanat, 1,4-Cyclohexylendiisocyanat, 1,3-Cyclopentylendiisocyanat, 1,4-Diisocyanatomethyl-cyclohexan und 1,1,3-Trimethyl-3-isocyanatomethyl-5-isocyanatocyclohexan.

Als Hydroxygruppen enthaltende Ester werden insbesondere Hydroxyethylmethacrylat und Hydroxypropylmethacrylat (n oder iso) sowie ferner die entsprechenden Acrylate verwendet. Mit Vorteil können jedoch auch folgende Verbindungen verwendet werden: 2-Hydroxy-butylmethacrylat, 4-Hydroxy-butylmethacrylat, 2-Hydroxy-cyclohexylmethacrylat und andere Hydroxyalkylmethacrylate mit bis zu 12, vorzugsweise bis zu 6 Kohlenstoffatomen im Alkylrest, Diethylenglykolmonomethacrylat, Triethylenglykolmonomethacrylat und andere Polyethylenglykolmonomethacrylate mit bis zu 5 Oxyethyleneinheiten, Trimethylolethandimethacrylat, Trimethylolpropandimethacrylat, Pentaerythrittrimethacrylat sowie die entsprechenden Acrylate.

Die polymerisierbaren Verbindungen der Formel I mit n = 3 und b = 0 werden dargestellt, indem die oben beschriebenen Hydroxyalkylamine mit Isocyanatgruppen enthaltenden Acryl- oder Alkylacrylsäureestern umgesetzt werden.

Als Isocyanatgruppen enthaltender Ester wird insbesondere Isocyanatoethyl(meth)acrylat eingesetzt. Mit Vorteil können jedoch auch folgende Verbindungen verwendet werden: 3-Isocyanatopropylmethacrylat, 4-Isocyanatobutylmethacrylat, Isocyanatoisohexylmethacrylat und andere Isocyanatoalkyl(meth)acrylate mit bis zu 12, vorzugsweise bis zu 6 Kohlenstoffatomen im Alkylrest.

Die polymerisierbaren Verbindungen der Formel I mit

Q = -Ń-E-Ń-, n = 4 und b = 1 oder b = 0

werden analog den polymerisierbaren Verbindungen mit Q = N hergestellt.

Die polymerisierbaren Verbindungen der Formel I mit

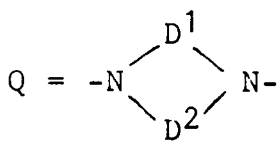

und b = 1 oder b = 0

werden ebenfalls analog den oben beschriebenen polymerisierbaren Verbindungen hergestellt.

Die Umsetzung der Isocyanate mit den OH-Gruppen enthaltenden Aminen und Alkylacrylaten wird zweckmäßig in einem inerten Lösungsmittel wie Toluol, Pyridin oder Methylethylketon durchgeführt. Zur thermischen Stabilisierung der stark zur Polymerisation neigenden Produkte werden Chinone, vorzugsweise Benzochinon, in Konzentrationen von 0,01 - 2 Gew.-% zugesetzt.

Die Verbindungen mit Q = S werden, ausgehend vom entsprechenden Bis-hydroxyalkyl-sulfid, analog den oben angegebenen allgemeinen Vorschriften hergestellt.

Neben anderen Bestandteilen sind die vorstehend beschriebenen polymerisierbaren Verbindungen für die sehr hohe Lichtempfindlichkeit der photopolymerisierbaren Gemische verantwortlich.

Außer den beschriebenen photooxydierbaren polymerisierbaren Verbindungen können auch herkömmliche polymerisierbare Verbindungen, die zwei oder mehr polymerisierbare Acryl- oder Methacrylsäureestergruppen enthalten, zugesetzt werden. Beispiele sind Acryl- und Methacrylsäureester von zwei-oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079, 23 61 041 und 28 22 190 beschrieben.

Der Mengenanteil des Gemischs an Monomeren beträgt im allgemeinen etwa 10 bis 80, vorzugsweise 20 bis 60 Gew.-%.

Das erfindungsgemäße Gemisch enthält als Photoinitiator einen photoreduzierbaren Farbstoff. Geeignete Farbstoffe sind insbesondere Xanthen-, Thiazin-, Pyronin, Porphyrin- oder Acridinfarbstoffe. Bevorzugte Vertreter der Xanthenfarbstoffe sind Verbindungen der allgemeinen Formel II

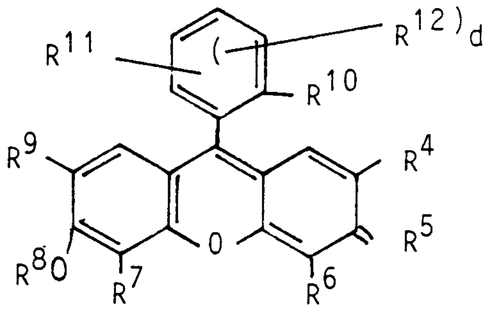

(II)

worin

| | |
|---|---|
| $R^4$ und $R^9$ | gleich oder verschieden sind und Wasserstoff-oder Halogenatome, Nitro- oder Hydroxygruppen oder Gruppen der Formel -HgOH bedeuten, |
| $R^6$ und $R^7$ | gleich oder verschieden sind und Wasserstoff-oder Halogenatome oder Hydroxygruppen, |
| $R^5$ | O oder $^{(+)}$NHAlkyl $X^{(-)}$, |
| $R^8$ | ein Wasserstoffatom, ein Alkalimetall-, Ammonium- oder Trialkylammoniumkation, eine Alkyl- oder Acylgruppe, |
| $R^{10}$ | ein Wasserstoffatom oder eine Gruppe $COOR^{13}$, |
| $R^{11}$ | ein Wasserstoff- oder Halogenatom oder eine Aminogruppe, |
| $R^{12}$ | ein Wasserstoff- oder Halogenatom, |
| $R^{13}$ | ein Wasserstoffatom, ein Alkalimetall- oder Ammoniumkation, eine Alkylgruppe oder ein polymerer Rest, |
| X | ein Anion und |
| d | Null oder eine ganze Zahl von 1 bis 3 bedeutet. |

Wenn die Reste $R^5$, $R^8$ und $R^{13}$ Alkylreste sind oder solche enthalten, haben diese im allgemeinen 1 bis 25, insbesondere 1 bis 18 Kohlenstoffatome.

Geeignete Thiazinfarbstoffe sind Verbindungen der Formel III und geeignete Pyroninfarbstoffe Verbindungen der Formel IV

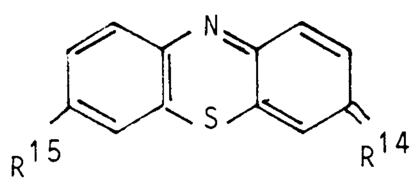

(III)

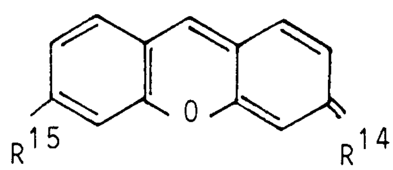

(IV)

worin

| | |
|---|---|
| $R^{14}$ | eine der Gruppen $=NH_2^{(+)} X^{(-)}$, $=NHAlkyl^{(+)} X^{(-)}$ und $=N(Alkyl)_2^{(+)} X^{(-)}$, |
| $R^{15}$ | eine Amino-, Alkylamino- oder Dialkylaminogruppe und |
| X | ein Anion ist. |

In den Formeln III und IV haben Alkylgruppen die gleiche Bedeutung wie in der Formel II.

Als Porphyrinfarbstoff ist z. B. Hämatoporphyrin und als Acridinfarbstoff z. B. Acriflaviniumchlorid-Hydrochlorid geeignet. Beispiele für Verbindungen der Formel II sind Eosin B (C.I. Nr. 45 400), Eosin J (C.I. Nr. 45 380), Eosin alkohollöslich (C.I. 45 386), Cyanosin (C.I. Nr. 45 410), Bengalrosa, Erythrosin (C.I. Nr. 45 430), 2,3,7-Trihydroxy-9-phenyl-xanthen-6-on und Rhodamin 6 G (C.I. Nr. 45 160).

Beispiele für Verbindungen der Formel III sind Thionin (C.I. Nr. 52 000), Azur A (C.I. Nr. 52 005) und Azur C (C.I. Nr. 52 002).

Beispiele für Farbstoffe der Formel IV sind Pyronin B (C.I. Nr. 45 010) und Pyronin GY (C.I. Nr. 45 005). Die Menge des Photoinitiators liegt im allgemeinen zwischen 0,01 und 10 Gew.-%, bezogen auf die nichtflüchtigen Anteile des Gemisches.

Zur weiteren Steigerung der Lichtempfindlichkeit können den erfindungsgemäßen Gemischen Verbindungen zugesetzt werden, die als radikalbildende Photoinitiatoren für photopolymerisierbare Gemische bekannt sind. Als derartige Coinitiatoren haben sich insbesondere Verbindungen mit photolytisch spaltbaren Trihalogenmethylgruppen bewährt. Als Halogene kommen besonders Chlor und Brom, insbesondere Chlor in Betracht. Die Trihalogenmethylgruppen können direkt oder über eine durchkonjugierte Kette an einen aromatischen carbo- oder heterocyclischen Ring gebunden sein. Besonders bevorzugt werden Verbindungen-

gen mit Triazinringen im Grundkörper und bevorzugt 2 Trihalogenmethylgruppen, insbesondere solche, wie sie in der EP-A 137 452, der DE-A 27 18 259 und der DE-A 22 43 621 beschrieben sind. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyltrihalogenmethyl-sulfone oder Phenyl-trihalogenmethylketone, z. B. das Phenyl-tribrommethylsulfon, sind geeignet.

Die Coinitiatoren werden im allgemeinen in einer Menge von 0,01 bis 10, vorzugsweise von 0,05 bis 4 Gew.-%, bezogen auf die nichtflüchtigen Bestandteile des Gemischs, eingesetzt.

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine und Celluloseether.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 30 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, die spektrale Empfindlichkeit derartiger Gemische modifizierende Stoffe, insbesondere 4,4′-disubstituierte Dibenzalacetone, z. B. 4-Diethylamino-4′-methoxy-dibenzalaceton, und Cumarinderivate, wie 3-Acetyl-7-diethylamino-cumarin, 3-Benzimidazolyl-7-diethylamino-cumarin oder Carbonyl-bis-(7-diethylamino-cumarin), Farbstoffe, gefärbte und ungefärbte Pigmente, Farbbildner, Indikatoren und Weichmacher.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Flachdruckplatten und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckplatten, vorliegen, Ebenso ist es für die Herstellung von

Trockenresist geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw.. Solche Deckschichten haben im allgemeinen eine Dicke von 0,1 bis 10, vorzugsweise 1 bis 5 µm.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösungsmittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und getrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Die Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Dabei wird zunächst in Tabelle I eine Anzahl neuer polymerisierbarer Verbindungen aufgeführt.

Die Herstellung dieser Verbindungen erfolgt nach einem der beiden nachstehend angegebenen Verfahren. Die Verbindungen werden in den nachfolgenden Beispielen in erfindungsgemäßen Aufzeichnungsmaterialien als polymerisierbare Verbindungen eingesetzt. In den Beispielen stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

1.) Allgemeine Vorschrift zur Darstellung der Verbindungen der allgemeinen Formel I mit b = 0 (Verbindungen 1, 4 und 5 in Tabelle I

Die Hydroxyalkylgruppen enthaltende Aminoverbindung und das Isocyanatoalkyl(meth)acrylat werden im gewünschten Molverhältnis in der zehnfachen Menge des geeigneten Lösungsmittels (Toluol, Butanon, Pyridin) mit 0,01 Gew.-% Dibutylzinndilaurat und 0,01 Gew.-% Benzochinon solange unter Rückfluß erhitzt, bis die Isocyanatbande (2275 - 2250 $cm^{-1}$) IR-spektroskopisch nicht mehr nachzuweisen ist (in der Regel nach 5 bis 8 Stunden). Anschließend wird das Lösungsmittel im Vakuum bei 50° C abdestilliert. Die ungesättigte Verbindung verbleibt als viskoser Rückstand in praktisch quantitativer Ausbeute.

2.) Allgemeine Vorschrift zur Darstellung der Verbindungen der allgemeinen Formel I mit b = 1 (Verbindungen 2 und 3 in Tabelle I).

Hydroxyalkyl(meth)acrylat und Diisocyanat werden im Molverhältnis 1:1 in der zehnfachen Menge Lösungsmittel (Toluol, Butanon, Pyridin) mit 0,01 Gew.-% Dibutylzinndilaurat und 0,01 Gew.-% Benzochinon 8 Stunden unter Rückfluß erhitzt und anschließend die gewünschte Molmenge Hydroxyalkylamin zugegeben und solange weiter unter Rückfluß erhitzt, bis die Isocyanatbande IR-spektroskopisch verschwunden ist (in der Regel 5-8 Stunden). Anschließend wird das Lösungsmittel im Vakuum bei 50° C abdestilliert. Die ungesättigte Verbindung verbleibt als viskoser Rückstand in praktisch quantitativer Ausbeute.

## Tabelle I

Verbindungen der allgemeinen Formel I mit $R^2$=H; $R^3$=$CH_3$; $X^2$ = $C_2H_4$

| Verb. Nr. | Q | R | $R^1$ | a | $X^1$ | b | m | n | $N_{ber.}$ | $N_{gef.}$ |
|---|---|---|---|---|---|---|---|---|---|---|
| 1 | -N- | - | H | 1 | - | 0 | 3 | 3 | 9,1 | 8,8 |
| 2 | -N- | - | H | 1 | *) | 1 | 3 | 3 | 8,4 | 8,7 |
| 3 | $-N-CH_2-CH_2-N-$ | - | H | 1 | $C_6H_{12}$ | 1 | 4 | 4 | 8,0 | 8,2 |
| 4 | $-N-CH_2-CH_2-N-$ | - | $CH_3$ | 1 | - | 0 | 4 | 4 | 9,1 | 8,8 |
| 5 | -N- | $C_2H_4OH$ | H | 1 | - | 0 | 3 | 2 | 10,1 | 9,5 |
| | | | - | 0 | - | 0 | | | | |

*) 2,2,4-Trimethyl-hexamethylen

### Beispiel 1

Als Schichtträger für Druckplatten wurde elektrochemisch aufgerauhtes und anodisiertes Aluminium mit einer Oxidschicht von 3 g/$m^2$ verwendet, das mit einer wäßrigen Lösung von Polyvinylphosphonsäure vorbehandelt worden war. Der Träger wurde mit einer Lösung folgender Zusammensetzung überzogen:

2,84 Gt einer 22,3 %igen Lösung eines Terpolymerisats aus Styrol, n-Hexylmethacrylat und Methacrylsäure (10:60:30) mit der Säurezahl 190 in Methylethylketon,
1,49 Gt Verbindung 1 und
0,04 Gt Eosin alkohollöslich (C.I. 45 386) in
22 Gt Propylenglykolmonomethylether.

Das Auftragen erfolgte durch Aufschleudern in der Weise, daß ein Trockengewicht von 2,8 bis 3 g/$m^2$ erhalten wurde. Anschließend wurde die Platte zwei Minuten bei 100° C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4 bis 5 g/$m^2$ erhalten. Die erhaltene Druckplatte wurde mittels einer 5 kW-Metallhalogenidlampe im Abstand von 110 cm unter einem 13-stufigen Belichtungskeil mit Dichteinkrementen von 0,15 belichtet. Um die Empfindlichkeit der Druckplatte im sichtbaren Licht zu testen, wurden auf den Belichtungskeil jeweils 3 mm starke Kantenfilter der Firma Schott mit den in der Tabelle angegebenen Kantendurchlässigkeiten montiert. Nach der Belichtung wurde die Platte eine Minute auf 100° c erwärmt. Anschließend wurde sie mit einem Entwickler folgender Zusammensetzung entwickelt:

120 Gt Natriummetasilikat • 9 $H_2O$,
2,13 Gt Strontiumchlorid,
1,2 Gt nichtionogenes Netzmittel (Kokosfettalkohol-Polyoxyethylenether mit ca. 8 Oxyethyleneinheiten) und

0,12 Gt Antischaummittel in
4000 Gt vollentsalztem Wasser.

Die Platte wurde mit fetter Druckfarbe eingefärbt. Es wurden die folgenden vollvernetzten Keilstufen erhalten:

Tabelle II

| Belichtung (Sekunden) | Kantenfilter | Keilstufen |
|---|---|---|
| 40 | - | 3 |
| 40 | 400 | 2 |
| 50 | 455 | 1 |

Mit einer oberhalb 455 nm belichteten Platte wurden Druckversuche durchgeführt, die nach 150.000 Drucken abgebrochen wurden, obwohl noch keine Ausbrüche im 60er Raster feststellbar waren.

Beispiel 2

Auf den in Beispiel 1 angegebenen Schichtträger wurde unter gleichen Bedingungen wie im Beispiel 1 eine Lösung folgender Zusammensetzung aufgeschleudert:
2,84 Gt der in Beispiel 1 angegebenen Terpolymerisatlösung,
1,4 Gt Verbindung 1 und
0,02 Gt Farbstoff in
22,0 Gt Propylenglykolmonomethylether.

Nach Auftragen einer Deckschicht aus Polyvinylalkohol wurden die Platten in gleicher Weise wie in Beispiel 1 100 Sekunden belichtet und dann entwickelt. Es wurde die folgende Anzahl vollvernetzter Keilstufen erhalten:

Tabelle III

| Farbstoff (C.I. Nr.) | Kantenfilter (nm) | Keilstufen |
|---|---|---|
| Cyanosin | - | 7 |
| (45 410) | 400 | 4 |
| | 455 | 3 |
| Thionin | - | 3 |
| (52 000) | 400 | 1 |
| | 455 | 1/2 |
| Hämatoporphyrin | - | 6 |
| | 400 | 1 |
| | 455 | - |

Verwendete man statt Verbindung 1 als ethylenisch ungesättigte Verbindung z. B. Trimethylolpropantriacrylat, wurde keine ausreichende Vernetzungsdichte erhalten.

Beispiel 3

Auf den in Beispiel 1 angegebenen Schichtträger wurden unter gleichen Bedingungen wie dort Lösungen folgender Zusammensetzung aufgeschleudert:
2,8 Gt der in Beispiel 1 angegebenen Terpolymerisatlösung,
1,4 Gt Monomeres,
0,02 Gt Eosin alkohollöslich und
0,08 Gt 2,4-Bis-trichlormethyl-6-(4-styryl-phenyl)-s-triazin in
22,0 Gt Propylenglykolmonomethylether
Die beschichteten Platten wurden anschließend 2 Minuten bei 100° C im Umlufttrockenschrank getrocknet und mit einer Deckschicht wie im Beispiel 1 versehen. Sie wurden, soweit angegeben, unter einem 13-stufigen Belichtungskeil, auf den zusätzlich ein Silberfilm mit gleichmäßiger Schwärzung (Dichte 1,57) und gleichmäßiger Absorption über den wirksamen Spektralbereich montiert wurde, 10 Sekunden belichtet und anschließend wie im Beispiel 1 entwickelt und beurteilt. Es wurde jeweils die folgende Anzahl Keilstufen erhalten:

Tabelle IV:

| Verbindung | Graufilter | Kantenfilter | Stufen |
|---|---|---|---|
| 2 | ja | - | 2 |
| | nein | 455 | 2 |
| 3 | ja | - | 3 |
| | nein | 455 | 3 |
| 5 | ja | - | 4 |
| | nein | 455 | 5 |

Beispiel 4

Auf den in Beispiel 1 angegebenen Schichtträger wurden Lösungen folgender Zusammensetzung so aufgeschleudert, daß nach dem Trocknen Schichtgewichte von 3 g/m$^2$ erhalten wurden:
2,8 Gt der in Beispiel angegebenen Terpolymerisatlösung,
1,4Gt Verbindung 1,
0,02 Gt Farbstoff und
0,08 Gt 2,4-Bis-trichlormethyl-6-(4-styrylphenyl)-s-triazin in
22,0 Gt Propylenglykolmonomethylether.

Die Platten wurden wie in Beispiel 3 verarbeitet, wonach die in Tabelle V angegebene Anzahl vollvernetzter Keilstufen erhalten wurde:

Tabelle V:

| Farbstoff | Belichtungszeit | Graufilter | Kantenfilter | Keilstufen |
|---|---|---|---|---|
| Hämatoporphyrin | 40 | ja | - | 8 |
| | 5 | nein | 455 | 3 |
| 2,3,7-Trihydroxy-9-phenyl-xanthen-6-on | 40 | ja | - | 9 |
| | 40 | nein | 455 | 2 |
| Thionin | 40 | ja | - | 4 |
| | 40 | nein | 455 | 2 |
| Cyanosin | 5 | ja | - | 4 |
| | 5 | nein | 455 | 3 |
| 2,7-Dichlorfluorescein | 40 | ja | - | 6 |
| | 40 | - | 455 | 3 |
| Acriflaviniumchlorid-Hydrochlorid | 10 | ja | - | 5 |
| | 10 | - | 455 | 2 |

Die Druckplatte mit Thionin als langwelligem Sensibilisator wurde mit einem He-Ne-Laser (632,8 nm) belichtet. Man erhielt eine ausreichende Vernetzungsdichte.

Beispiel 5

Auf den in Beispiel 1 angegebenen Schichtträger wurde eine Lösung folgender Zusammensetzung so aufgeschleudert, daß nach dem Trocknen ein Schichtgewicht von 3 g/m$^2$ erhalten wurde:

2,8 Gt einer 33,4 %igen Lösung eines Methylmethacrylat/Methacrylsäure-Mischpolymerisats mit der Säurezahl 110 und dem mittleren Molekulargewicht 35.000 in Butanon,
1,4 Gt Verbindung 1,
0,02 Gt Eosin alkohollöslich und
0,05 Gt Halogenverbindung gemäß Tabelle VI in
22,0 Gt Propylenglykolmonomethylether.

Die Platten wurden wie in Beispiel 3 verarbeitet, wonach die in Tabelle VI angegebene Anzahl vollvernetzter Keilstufen erhalten wurde:

Tabelle VI:

| Halogenverbindung | Graufilter | Kantenfilter | Stufen |
|---|---|---|---|
| 2,4-Bis-trichlormethyl-6-(5-methoxynaphth-1-yl)-s-triazin | ja | - | 3 |
| | nein | 455 | 2 |
| Phenyl-tribrommethyl-sulfon | nein | - | 5 |
| | nein | 455 | 2 |

Beispiel 6

Die Druckplatte aus Beispiel 4 mit Cyanosin als langwelligem Sensibilisator wurde mit einem aufgeweiteten Argon-Ionen-Laserstrahl belichtet. Dabei hatte der Laserstrahl mit der Wellenlänge 514 nm eine Energie von 0,2 mW/cm$^2$. Nach 25 Sekunden Belichtungszeit war die Schicht vollvernetzt.

Beispiel 7

Auf den in Beispiel 1 angegebenen Schichtträger wurde eine Lösung folgender Zusammensetzung so aufgeschleudert, daß ein Schichtgewicht von 3 g/m$^2$ erhalten wurde:
2,84 Gt der in Beispiel 1 angegebenen Terpolymerisatlösung,
0,7 Gt Verbindung gemäß Tabelle VII,
0,7 Gt Trimethylolpropantriacrylat,
0,2 Gt Eosin alkohollöslich und
0,08 Gt 2,4-Bis-trichlormethyl-6-(4-styrylphenyl)-s-triazin in
22,0 Gt Propylenglykolmonomethylether.

Die Platten wurden in gleicher Weise wie im Beispiel 1 verarbeitet. Nach 40 Sekunden Belichtungszeit wurde die folgende Anzahl vollvernetzter Keilstufen erhalten:

Tabelle VII:

| Verbindung | Graufilter | Kantenfilter | Keilstufen |
|---|---|---|---|
| 1 | ja | - | 5 |
| | nein | 455 | 5 |
| 4 | ja | - | 8 |
| | nein | 455 | 7 |

Beispiel 8

Auf den in Beispiel 1 angegebenen Schichtträger wurde eine Lösung folgender Zusammensetzung so aufgeschleudert, daß ein Schichtgewicht von 3 g/m² erhalten wurde:
2,84 Gt der in Beispiel 1 angegebenen Terpolymerisatlösung,
1,4 Gt Verbindung 1,
0,1 Gt Carbonylverbindung gemäß Tabelle VIII,
0,02 Gt Eosin alkohollöslich und
0,08 Gt 2,4-Bis-trichlormethyl-6-(4-styryl-phenyl)-s-triazin in
22,0 Gt Propylenglykolmonomethylether.

Die Platten wurden in gleicher Weise wie im Beispiel 1 verarbeitet. Nach 40 Sekunden Belichtung wurde jeweils die folgende Anzahl vollvernetzter Keilstufen erhalten:

Tabelle VIII:

| Carbonylverbindung | Graufilter | Kantenfilter | Keilstufen |
|---|---|---|---|
| 4-Dimethylamino-4'-methoxy-dibenzal-aceton | ja | - | 3 |
| | nein | 455 | 4 |
| 3-Acetyl-7-diethyl-amino-cumarin | ja | - | 8 |
| | nein | 455 | 10 |

Die Wirksamkeit der zugesetzten Verbindungen wurde am Auflösungsvermögen der Kopie abgelesen, das mit dem FOGRA-PMS-Stufenkeil bestimmt wurde. Die oben angegebene Mischung ohne Dibenzal- oder Cumarinderivat ergab jeweils eine um eine Stufe im K-Feld des Keils schlechtere Auflösung.

Beispiel 9

Die Beschichtungslösung aus Beispiel 4 mit Cyanosin als langwelligem Sensibilisator wurde auf eine biaxial verstreckte 35 µm dicke Polyethylenterephthalat-Folie so aufgeschleudert, daß nach dem Trocknen ein Schichtgewicht von 5 g/m² erhalten wurde. Die Schicht wurde 3 Minuten bei 100° C im Umlufttrockenschrank nachgetrocknet. Anschließend wurde die Schicht bei 115° C mit 1,5 m/s auf einen gereinigten Träger laminiert, der aus einem Isoliermaterial mit 35 µm Kupferauflage bestand.

Die Schicht wurde mittels einer 5 kW-Metallhalogenidlampe (140 cm Abstand) unter einem Kantenfilter 455, wie im Beispiel 1 beschrieben, und unter einem Stufenkeil 30 Sekunden belichtet und nach Abziehen der Folie mit 0,8 %iger Sodalösung in einem Sprühprozessor 20 Sekunden entwickelt. Es wurden 4 vollvernetzte Keilstufen erhalten. Die vernetzte Schicht war gegen die in der Leiterplattentechnik übliche Eisen-III-chlorid-Lösung resistent. Die Ätzfestigkeit war gut.

**Patentansprüche**

**1.** Photopolymerisierbares Gemisch, das als wesentliche Bestandteile
a) ein polymeres Bindemittel,
b) einen Acryl- oder Alkacrylsäureester eines mehrwertigen Alkohols und
c) einen photoreduzierbaren Farbstoff als Photoinitiator enthält, dadurch gekennzeichnet, daß der Acryl- oder Alkacrylsäureester eine oder mehrere bei Belichtung in Gegenwart des photoreduzierbaren Farbstoffs photooxydierbare Gruppen und eine oder mehrere Urethangruppen aufweist.

**2.** Gemisch nach Anspruch 1, dadurch gekennzeichnet, daß der Acryl- oder Alkacrylsäureester eine Verbindung der Formel I

$$R_{(m-n)}Q[(-CH_2-\underset{R^2}{\overset{R^1}{C}}O)_a-CONH(X^1-NHCOO)_b-X^2(-OOC-\overset{R^3}{C}=CH_2)_c]_n \quad (I)$$

ist, worin

| | |
|---|---|
| Q | -Ń-, -Ń-E-Ń-, 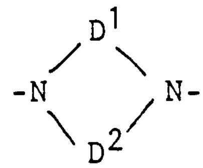 ODER -S- |
| R | eine Alkyl-, Hydroxyalkyl- oder Arylgruppe, |
| $R^1$ und $R^2$ | jeweils ein Wasserstoffatom, eine Alkylgruppe oder Alkoxyalkylgruppe, |
| $R^3$ | ein Wasserstoffatom, eine Methyl- oder Ethylgruppe, |
| $X^1$ | eine gesättigte Kohlenwasserstoffgruppe mit 2 bis 12 Kohlenstoffatomen, |
| $X^2$ | eine (c + 1)-wertige gesättigte Kohlenwasserstoffgruppe, in der bis zu 5 Methylengruppen durch Sauerstoffatome ersetzt sein können, |
| $D^1$ und $D^2$ | jeweils eine gesättigte Kohlenwasserstoffgruppe mit 1 bis 5 Kohlenstoffatomen, |
| E | eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern, |
| a | 0 oder eine ganze Zahl von 1 bis 4, |
| b | 0 oder 1, |
| c | eine ganze Zahl von 1 bis 3, |
| m | je nach Wertigkeit von Q 2, 3 oder 4 und |
| n | eine ganze Zahl von 1 bis m |

bedeutet, wobei alle Reste gleicher Definition untereinander gleich oder verschieden sein können.

**3.** Gemisch nach Anspruch 2, dadurch gekennzeichnet, daß n = m ist.

**4.** Gemisch nach Anspruch 2, dadurch gekennzeichnet, daß E eine gesättigte Alkylengruppe mit 2 bis 4 Kohlenstoffatomen ist.

**5.** Gemisch nach Anspruch 2, dadurch gekennzeichnet, daß $R^3 = CH_3$ ist.

**6.** Gemisch nach Anspruch 2, dadurch gekennzeichnet, daß a + b = 1 oder 2 ist.

**7.** Gemisch nach Anspruch 1, dadurch gekennzeichnet, daß der photoreduzierbare Farbstoff ein Xanthen-, Thiazin-, Pyronin-, Porphyrin- oder Acridinfarbstoff ist.

**8.** Gemisch nach Anspruch 7, dadurch gekennzeichnet, daß der Xanthenfarbstoff eine Verbindung der Formel II

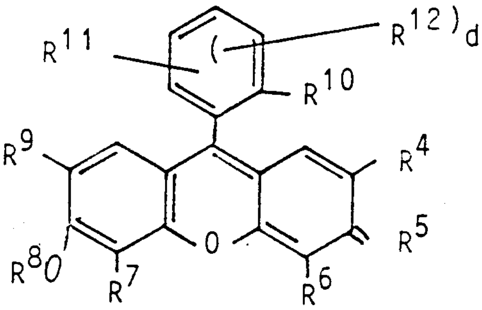

(II)

ist, worin

- $R^4$ und $R^9$ gleich oder verschieden sind und Wasserstoff- oder Halogenatome, Nitro- oder Hydroxygruppen oder Gruppen der Formel -HgOH bedeuten,
- $R^6$ und $R^7$ gleich oder verschieden sind und Wasserstoff- oder Halogenatome oder Hydroxygruppen,
- $R^5$ O oder $^{(+)}$NHAlkyl $X^{(-)}$,
- $R^8$ ein Wasserstoffatom, ein Alkalimetall-, Ammonium- oder Trialkylammoniumkation, eine Alkyl- oder Acylgruppe,
- $R^{10}$ ein Wasserstoffatom oder eine Gruppe $COOR^{13}$,
- $R^{11}$ ein Wasserstoff- oder Halogenatom oder eine Aminogruppe,
- $R^{12}$ ein Wasserstoff- oder Halogenatom,
- $R^{13}$ ein Wasserstoffatom, ein Alkalimetall- oder Ammoniumkation, eine Alkylgruppe oder ein polymerer Rest,
- X ein Anion und
- d Null oder eine ganze Zahl von 1 bis 3 bedeutet.

**9.** Gemisch nach Anspruch 7, dadurch gekennzeichnet, daß der Farbstoff eine Verbindung einer der Formeln III und IV

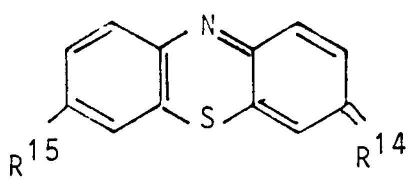

(III)

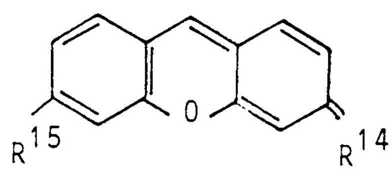

(IV)

ist, worin

- $R^{14}$ eine der Gruppen $=NH_2^{(+)}X^{(-)}$, $=NHAlkyl^{(+)}X^{(-)}$ und $=N(Alkyl)_2^{(+)}X^{(-)}$,
- $R^{15}$ eine Amino-, Alkylamino- oder Dialkylaminogruppe und
- X ein Anion ist.

**10.** Gemisch nach Anspruch 1, dadurch gekennzeichnet, daß das Bindemittel wasserunlöslich und in wäßrigalkalischen Lösungen löslich ist.

**11.** Gemisch nach Anspruch 1, dadurch gekennzeichnet, daß es 10 bis 80 Gew.-% Acryl- oder Alkacrylsäureester, 20 bis 90 Gew.-% polymeres Bindemittel und 0,01 bis 10 Gew.-%, bezogen auf die nichtflüchtigen Bestandteile des Gemischs, des photoreduzierbaren Farbstoffs enthält.

**12.** Gemisch nach Anspruch 1, dadurch gekennzeichnet, daß es zusätzlich eine Verbindung enthält, die bei Belichtung Radikale bildet, die die Polymerisation des Acryl- oder Alkacrylsäureesters einzuleiten vermögen.

**13.** Gemisch nach Anspruch 12, dadurch gekennzeichnet, daß die Radikale bildende Verbindung ein s-Triazin, das durch mindestens eine Trihalogenmethylgruppe und eine weitere Gruppe substituiert ist, oder ein Aryltrihalogenmethylsulfon ist.

**14.** Gemisch nach Anspruch 13, dadurch gekennzeichnet, daß die weitere Gruppe mindestens einen aromatischen Kern enthält, der direkt oder über ein durchkonjugiertes Doppelbindungssystem mit dem Triazinrest verbunden ist.

**15.** Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

## Claims

**1.** A photopolymerizable mixture which contains, as essential components,

a) a polymeric binder,

b) an acrylate or alkacrylate of a polyhydric alcohol, and

c) a photoreducible dye as photoinitiator,

characterized in that the acrylate or alkacrylate contains one or more groups which are photooxidizable on exposure in the presence of the photoreducible dye, and one or more urethane groups.

**2.** A mixture as claimed in claim 1, wherein the acrylate or alkacrylate is a compound of the formula I

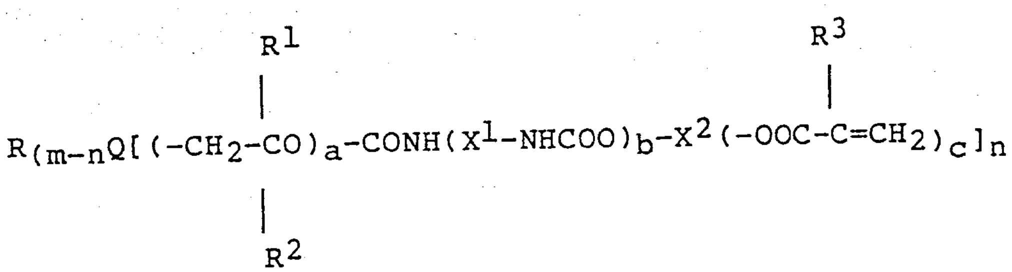 (I)

in which

Q denotes -Ń-, -Ń-E-Ń-,

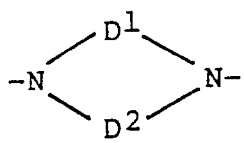

or -S-,

R denotes an alkyl, hydroxyalkyl or aryl group,

$R^1$ and $R^2$ each denote a hydrogen atom, an alkyl group or an alkoxyalkyl group,

$R^3$ denotes a hydrogen atom, a methyl group or an ethyl group,

$X^1$ denotes a saturated hydrocarbon group having 2 to 12 carbon atoms,

$X^2$ denotes a (c+1)-valent saturated hydrocarbon group in which up to 5 methylene groups may be replaced by oxygen atoms,

$D^1$ and $D^2$ each denote a saturated hydrocarbon group having 1 to 5 carbon atoms,

E denotes a saturated hydrocarbon group having 2 to 12 carbon atoms, a cycloaliphatic group which has 5 to 7 ring members and which contains, where appropriate, up to 2 N, O or S atoms as ring members, an arylene group having 6 to 12 carbon atoms, or a heterocyclic aromatic group having 5 or 6 ring members,

a denotes 0 or an integer from 1 to 4,

b denotes 0 or 1,

c denotes an integer from 1 to 3,

m denotes 2, 3 or 4, depending on the valency of Q, and

n denotes an integer from 1 to m,

it being possible for all radicals of the same definition to be identical to or different from one another.

**3.** A mixture as claimed in claim 2, wherein n = m.

**4.** A mixture as claimed in claim 2, wherein E is a saturated alkylene group having 2 to 4 carbon atoms.

**5.** A mixture as claimed in claim 2, wherein $R^3 = CH_3$.

**6.** A mixture as claimed in claim 2, wherein a + b = 1 or 2.

**7.** A mixture as claimed in claim 1, wherein the photoreducible dye is a xanthene, thiazine, pyronine, porphyrine or acridine dye.

**8.** A mixture as claimed in claim 6, wherein the xanthene dye is a compound of the formula II

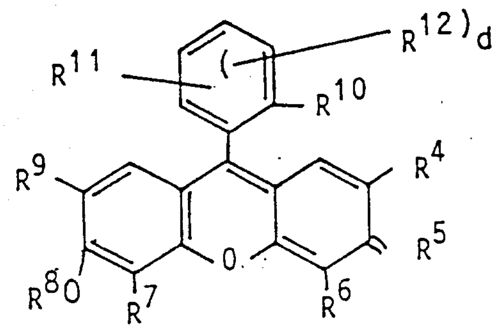

(II)

in which

| | |
|---|---|
| $R^4$ and $R^9$ | are identical or different and denote hydrogen or halogen atoms, nitro or hydroxyl groups or groups of the formula -HgOH, |
| $R^6$ and $R^7$ | are identical or different and denote hydrogen or halogen atoms or hydroxyl groups, |
| $R^5$ | denotes 0 or $^{(+)}$NHalkyl $X^{(-)}$, |
| $R^8$ | denotes a hydrogen atom, an alkali metal, ammonium or trialkylammonium cation, or an alkyl or acyl group, |
| $R^{10}$ | denotes a hydrogen atom or a $COOR^{13}$ group, |
| $R^{11}$ | denotes a hydrogen or halogen atom or an amino group, |
| $R^{12}$ | denotes a hydrogen or halogen atom, |
| $R^{13}$ | denotes a hydrogen atom, an alkali metal or ammonium cation, an alkyl group or a polymeric radical, |
| X | denotes an anion, and |
| d | denotes zero or an integer from 1 to 3. - |

**9.** A mixture as claimed in claim 7, wherein the dye is a compound of one of the formulae III and IV

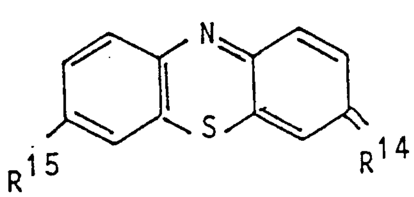

(III)

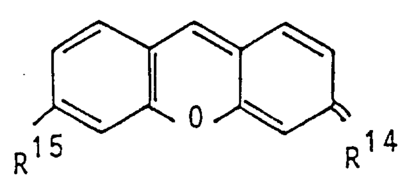

(IV)

in which

| | |
|---|---|
| $R^{14}$ | is one of the groups $=NH_2^{(+)} X^{(-)}$, $=NHalkyl^{(+)} X^{(-)}$ and $=N(alkyl)_2^{(+)} X^{(-)}$, |
| $R^{15}$ | is an amino, alkylamino or dialkylamino group and |
| X | is an anion. |

**10.** A mixture as claimed in claim 1, wherein the binder is insoluble in water and soluble in aqueous-alkaline solutions.

**11.** A mixture as claimed in claim 1, which contains 10 to 80 % by weight of acrylate or alkacrylate, 20 to 90 % by weight of polymeric binder and 0.01 to 10 % by weight, relative to the nonvolatile components

of the mixture, of the photoreducible dye.

**12.** A mixture as claimed in claim 1, which further contains a compound which on exposure forms free radicals which are capable of initiating polymerization of the acrylate or alkacrylate.

**13.** A mixture as claimed in claim 12, wherein the free radical-forming compound is an s-triazine which is substituted by at least one trihalomethyl group and one further group or is an aryl trihalomethyl sulfone.

**14.** A mixture as claimed in claim 13, wherein the further group contains at least one aromatic ring which is connected to the triazine radical either directly or via a conjugated double bond system.

**15.** A photopolymerizable recording material comprising a layer support and a photopolymerizable layer, wherein the photopolymerizable layer comprises a mixture as claimed in claim 1.

## Revendications

**1.** Composition photopolymérisable, qui contient comme constituants principaux:
a) un liant polymère,
b) un ester d'acide acrylique ou alkylacrylique et d' un polyol, et
c) un colorant photoréductible comme amorceur photochimique,
caractérisée en ce que l'ester d'acide acrylique ou alkylacrylique possède un ou plusieurs groupe(s) photooxydable(s) par exposition à la lumière en présence du colorant photoréductible, et un eu plusieurs groupe(s) uréthane.

**2.** Composition selon la revendication 1, caractérisée en ce que l'ester d' acide acrylique ou d'acide alkylacrylique est un composé de formule I

$$R_{(m-n)}Q[(-CH_2-\underset{R^2}{\overset{R^1}{C}}O)_a-CONH(X^1-NHCOO)_b-X^2(-OOC-\overset{R^3}{C}=CH_2)_c]_n \quad (I)$$

dans laquelle les différents symboles représentent:

Q -Ń- -Ń-E-Ń-

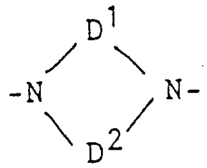

ou -S-

R un groupe alkyle, hydroxyalkyle ou aryle,

$R^1$ et $R^2$ chacun un atome d' hydrogène, un groupe alkyle ou un groupe alcoxyalkyle,

$R^3$ l'atome d'hydrogène ou un groupe méthyle ou éthyle,

$X^1$ un groupe hydrocarboné saturé en $C_{2-12}$,

$X^2$ un groupe hydrocarboné saturé (c+1)valent, dans lequel jusqu'à 5 groupes méthylène peuvent être remplacés par des atomes d'oxygène.

$D^1$ et $D^2$ chacun un groupe hydrocarboné saturé en $C_{1-5}$,

E un groupe hydrocarboné saturé en $C_{2-12}$, un groupe cylcoaliphatique comportant de 5 à 7 chaînons, qui renferme éventuellement jusqu'à deux atomes N, O ou S comme chaînons cycliques, un groupe arylène en $C_{6-12}$ ou un groupe aromatique hétérocylique pentagonal ou hexagonal,

a 0 eu un nombre entier de 1 à 4,

b 0 ou 1,

c un nombre entier de 1 à 3,
m selon la valence de Q: 2, 3 ou 4, et
n un nombre entier de 1 à m,

tous les radicaux de même définition pouvant être identiques ou différents les uns des autres.

**3.** Composition selon la revendication 2, caractérisée en ce que n = m.

**4.** Composition selon la revendication 2, caractérisée en ce que E représente un groupe alkylène saturé en $C_{2-4}$.

**5.** Composition selon la revendication 2, caractérisée en ce que $R^3 = CH_3$.

**6.** Composition selon la revendication 2, caractérisée en ce que a + b = 1 ou 2.

**7.** Composition selon la revendication 1, caractérisée en ce que le colorant photoréductible est un colorant xanthène, thiazine, pyronine, porphyrine ou acridine.

**8.** Composition selon la revendication 7, caractérisée en ce que le colorant xanthène est un composé de formule II

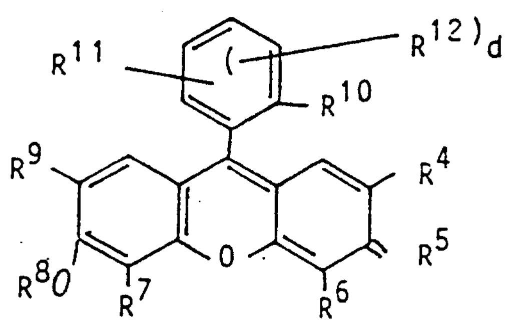

(II)

dans laquelle

$R^4$ et $R^9$, identiques ou différents, représentent des atomes d'hydrogène ou d'halogène, des groupes nitro ou hydroxyle ou des groupes de formule HgOH,
$R^6$ et $R^7$, identiques ou différents, représentent des atomes d'hydrogène ou d' halogène ou des groupes hydroxyle,
$R^5$ représente O ou $^{(+)}$NHalkyl $X^{(-)}$,
$R^8$ représente l'atome d'hydrogène, un cation de metal alcalin, ammonium ou trialkylammonium, un groupe alkyle ou acyle,
$R^{10}$ représente l'atome d'hydrogène ou un groupe $COOR^{13}$,
$R^{11}$ représente un atome d'hydrogène ou d'halogène ou un groupe amino,
$R^{12}$ représente un atome d'hydrogène ou d'halogène,
$R^{13}$ représente l'atome d'hydrogène, un cation de métal alcalin ou un cation ammonium, un groupe alkyle ou un radical polymère,
X représente un anion, et
d vaut 0, ou est un nombre entier de 1 à 3.

**9.** Composition selon la revendication 7, caractérisée en ce que le colorant est un composé de formules III ou IV

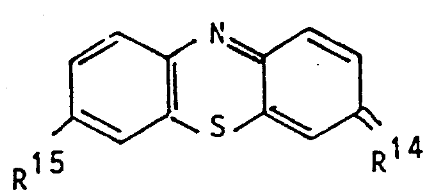

(III)

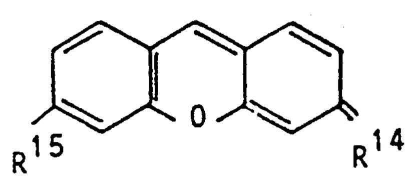

(IV)

dans lesquelles

$R^{14}$ est un des groupes $=NH_2^{(+)}X^{(-)}$, $=NHalkyl^{(+)}X^{(-)}$ et $=N\ (alkyl)_2^{(+)}X^{(-)}$,

$R^{15}$ représente un groupe amino, alkylamino ou dialkylamino, et

X est un anion.

**10.** Composition selon la revendication 1, caractérisée en ce que le liant est insoluble dans l'eau et soluble dans les solutions hydro-alcalines.

**11.** Composition selon la revendication 1, caractérisée en ce qu'elle contient de 10 à 80 % ; en poids d'ester d'acide acrylique ou alkylacrylique, de 20 à 90 % en poids de liant polymère et de 0,01 à 10 % en poids, par rapport aux constituants non volatils de la composition, de colorant photoréductible.

**12.** Composition selon la revendication 1, caractérisée en ce qu'elle contient en outre un composé qui, par exposition à la lumière, fournit des radicaux qui permettent d'induire la polymérisation de l'ester d'acide acrylique ou alkylacrylique.

**13.** Composition selon la revendication 12, caractérisée en ce que le composé formant les radicaux est une s-triazine qui est substituée par au moins un groupe trihalogénométhyle et par un autre groupe, ou bien une aryltrihalogénométhylsulfone.

**14.** Composition selon la revendication 13, caractérisée en ce que l'autre groupe contient au moins un noyau aromatique, qui est lié au reste triazine directement ou par l'intermédiaire d'un système de doubles liaisons conjuguées.

**15.** Matériau d'enregistrement reprographique photopolymérisable comprenant un support de couche et une couche photopolymérisable, caractérisé en ce que la couche photopolymérisable se compose d'un mélange selon la revendication 1.